# EUROPEAN PATENT APPLICATION

(11) **EP 2 211 388 A1**
(43) Date of publication of application: **28.07.2010**
(21) Application number: 08848953.9
(22) Date of filing: 11.11.2008
(51) Int. Cl.: H01L 31/04

(54) **SOLAR BATTERY CELL**

(30) Priority: 15.11.2007 JP 2007296603
(71) Applicant: Hitachi Chemical Company, Ltd., Tokyo 163-0449 (JP)
(72) Inventor: The designation of the inventor has not yet been filed
(74) Representative: von Kreisler Selting Werner
(86) International application number: PCT/JP2008/070451
(87) International publication number: WO 2009/063841

(57) **Abstract**

Disclosed is a solar battery cell comprising: a crystalline silicon substrate; a cell electrode for extracting external electric power formed on a light-receiving surface of the crystalline silicon substrate; a front surface tab line connected to the cell electrode; a rear surface electrode formed on a reverse light-receiving surface of the crystalline silicon substrate; and a rear surface tab line connected to the rear surface electrode, wherein the rear surface electrode and the rear surface tab line are connected with a resin conductive paste or conductive film, and the rear surface electrode is uniformly formed on the reverse light-receiving surface of the crystalline silicon substrate. The solar battery cell can make the efficiency of electric power generation improving and make costs for members thereof decreasing.

## Description

### Technical Field

The present invention relates to a solar battery cell.

### Background Art

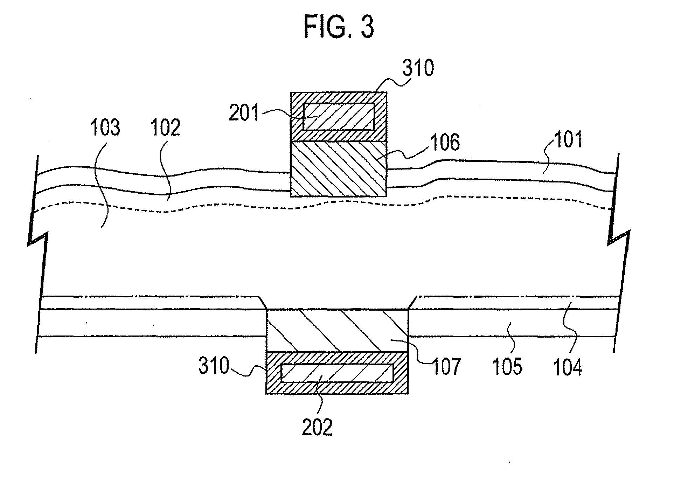

As illustrated in FIG. 3, which is a schematic view (sectional view), a conventional silicon-crystalline-type solar battery cell has a structure wherein: a crystalline silicon substrate is composed of an n layer 102, a p layer 103 and a P⁺ layer 104 based on the diffusion of aluminum atoms from an aluminum layer 105; an antireflective coating 101 is formed on a light-receiving surface of the crystalline silicon substrate to restrain the reflection of light with which the surface is irradiated; a front surface tab line 201 as an extemal-lead-out conducting wire and a cell electrode 106 for extracting external electric power are connected to each other with a solder 310; and the aluminum layer 105, a rear surface silver electrode 107 and a rear surface tab line 202 are fonned on the reverse light-receiving surface.

On the reverse light-receiving surface of the solar battery cell, the aluminum layer 105 is provider in a wide area in order to restrain electricity generated on the reverse light-receiving surface side from decreasing by the resistance. Copper, which is usually used for the rear surface tab line 202, and the aluminum layer 105 are not easily connected electrically to each other. Thus, the rear surface silver electrode 107 is arranged to collect electricity generated in the aluminum layer 105. However, in order to keep the adhesion of the rear surface silver electrode certainly, a region having no aluminum is made and the rear surface electrode 202 is formed therein. For the connection of this rear surface silver electrode 107 to the rear surface tab line 202, the solder 310 is used.

In order to make the thermal expansion coefficient of such a tab line small, and not to break a silicon wafer made thin, suggested is a tab line including a coating conductor and a core conductor (see, for examples, Japanese Patent Application Laid-Open (JP-A) No. 2004-204256). The solar battery cell has a structure wherein a silver-plating component is required for the region where the wafer is connected to the tab line.

In the meantime, suggested is a light solar battery unit or light solar battery module about which the use of expensive material is decreased and the production process is made simple (see, for example, JP-ANo. 2005-101519).

### Disclosure of the Invention

In JP-ANo. 2004-204256, it is essential to make the tab line small in thermal expansion and very good in corrosion resistance, and use silver for the rear surface electrode.

In the structure of the solar battery cell described in JP-A No. 2005-101519, a film-form adhesive having anisotropic conductivity is used instead of solder. However, it is essential to use silver for the rear surface electrode.

As illustrated in FIG 3, in the above-mentioned conventional solar battery cell, no aluminum layer is present in the area around the rear surface silver electrode 107 so that no P⁺ layer 104 is formed. Thus, the cell is in a disadvantageous form as an electric power generating element. As a result, the cell is also disadvantageous for the electric generation efficiency thereof.

In the conventional manner, the solder 310 0 is used to connect the rear surface tab line 202 and the rear surface silver electrode 107 to each other, and a heat for a temperature of about 260°C is required therefor. At this time, because of a difference in thermal expansion coefficient between the crystalline silicon substrate and copper, which is the tab line material, the cell is warped to be easily cracked. Thus, the yield is unfavorably declined.

Furthermore, it needs to use silver, which is expensive, as the material of the electrode on the reverse light-receiving surface of the crystalline silicon substrate.

The present invention is an invention for lessening such problems, and an object thereof is to supply a solar battery cell capable of improving the efficiency of electric power generation and further decreasing costs for members thereof.

In order to solve the problems, the inventors have made eager investigations to find out that a resin conductive paste or conductive film is used to connect a rear surface electrode and a rear surface tab line to each other, thereby removing a region having no P⁺ layer and preventing the cell from being warped or cracked by solder, so that the above-mentioned problems can be solved.

Accordingly, the present invention is as follows:

The solar battery of the present invention comprises: a crystalline silicon substrate;
a cell electrode for extracting eternal electric power formed on a light-receiving surface of the crystalline silicon substrate;
a front surface tab line connected to the cell electrode;
a rear surface electrode formed on a reverse light-receiving surface of the crystalline silicon substrate; and
a rear surface tab line connected to the rear surface electrode,
wherein the rear surface electrode and the rear surface tab line are connected with a resin conductive paste or conductive film, and the rear surface electrode is uniformly formed on the reverse light-receiving surface of the crystalline silicon substrate.

In the solar battery of the present invention, it is preferred that the connection of the front surface tab line to the cell electrode is also attained by the/a resin conductive paste or conductive film.

Wastes of the element structure are removed, thereby making it possible to provide a solar battery cell capable of improving the efficiency of electric power generation and further decreasing costs for members thereof.

### Brief Description of the Drawings

FIG. 1 is a structural view (cross section) of a solar battery cell of the present invention, and its tab lines.
FIG 2 is a structural view (cross section) of a solar battery cell of the present invention, and its tab lines.
FIG. 3 is a structural view (cross section) of a conventional solar battery cell, and its tab lines.

### Best Mode for Carrying Out the Invention

The solar battery cell of the present invention is a solar battery cell wherein a crystalline silicon substrate is used.

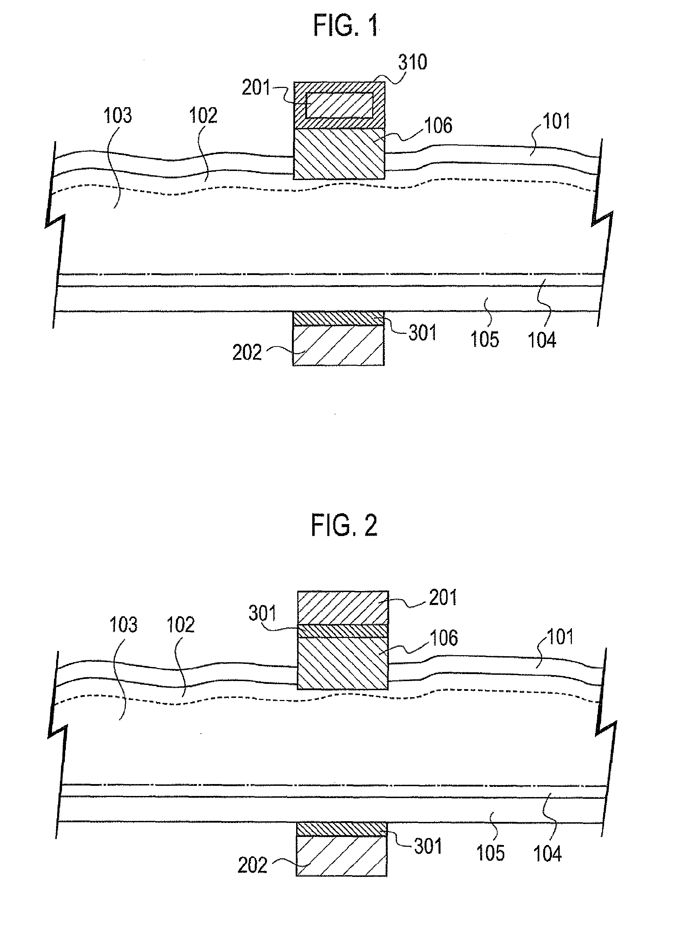

As illustrated in FIG. 1, the solar battery cell of the present invention has:
a crystalline silicon substrate comprising: an n layer 102; a p layer 103; and a p⁺ layer 104;
an antireflective coating 101 formed on a light-receiving surface (front surface) of the crystalline silicon substrate; and
an aluminum layer 105,as a rear surface electrode, formed on the reverse light-receiving surface (rear surface) of the crystalline silicon substrate. In order to connect the aluminum layer 105 as the rear surface electrode and a rear surface tab line 202 to each other, a resin conductive paste or conductive film 301 is used. In other words, in the present invention, the resin conductive paste or conductive film 301 is used to make it possible to connect the rear surface tab line 202 directly to the aluminum layer 105, whereby it becomes unnecessary that the reverse light-receiving surface should hae any silver electrode. Thus, the aluminum layer can be provided over the whole of the surface, whereby the P⁺ layer is also formed on the whole of the surface so that the internal structure of the cell is also changed. In the solar battery cell of the present invention, it becomes unnecessary to arrange any silver electrode, which is expensive, onto the reverse light-receiving surface. As a result, costs can be decreased.

Furthermore, in order to connect the rear surface tab line 202 to the aluminum layer 105 as the rear surface electrode, the resin conductive paste or conductive film 301 is used without using any solder, thereby lowering the temperature required for the connection into the range of 150 to 180°C. This matter makes it possible to decrease the above-mentioned warps or cracks in the cell. As a result, the yield can be made high.

In the light-receiving surface (front surface), a solder 310 may be used to connect a cell electrode 106 for extracting external electric power to a front surface tab line 201. However, as illustrated in FIG 2, in order to connect the cell electrode 106 for extracting external electric power to the front surface tab line 201, it is preferred to use the resin conductive paste or conductive film 301 instead of the solder.

In the solar battery cell of the present invention, wherein the crystalline silicon is used, the aluminum layer using an aluminum paste, is formed on the reverse light-receiving surface of the p layer 103. The aluminum layer is a rear surface electrode; thus, it is unnecessary to provide any rear surface silver electrode, so that the aluminum layer does not need to be patterned for extracting any electrode. Accordingly, the aluminum layer is formed into the form of a uniform film on the reverse light-receiving surface of the p layer 103. Thus, the aluminum layer can be made into a non-patterned film. As a result, when the aluminum paste is fired, aluminum in the aluminum paste diffuses into silicon of the crystalline silicon substrate on the reverse light-receiving surface side, thereby making it possible to form, onto the whole of the reverse light-receiving surface of the p layer 103, the P⁺ layer 104 uniformly as a BSF (back surface field) layer for improving the capability of electric power generation.

It is also preferred to locate the tab line onto the whole of the surface of the aluminum layer 105 since the resistance value can be lowered.

The solar battery cell of the present invention may be applied to a solar battery module, a process for producing the module, and the like.

The resin conductive paste used in the solar battery cell of the present invention may be a mixture wherein a conductive material is mixed with a resin in an amount of 1 to 1000 parts by volume relative to 100 parts by volume of the resin, examples of the conductive material including metal particles, a thin-piece form metal, metal-plated plastic particles, and low melting-point solder particles, and examples of the resin including a thermosetting epoxy resin composition and a thermosetting acrylic resin composition.

The resin conductive film may be a product obtained by processing, into a film form, a mixture wherein a conductive material is mixed with a resin in an amount of 1 to 1000 parts by volume relative to 100 parts by volume of the resin, examples of the conductive material including metal particles, a thin-piece form metal, metal-plated plastic particles, low melting-point solder particles and carbon particles, and examples of the resin including a thermosetting epoxy resin composition and a thermosetting acrylic resin composition.

Examples of the metal particles include particles in nickel, silver or gold particles. Examples of the thin-piece form metal include thin-pieces in nickel, silver, gold, or other metal. Examples of the metal plating in the metal-plated plastic particles include plating with nickel, silver or gold. Examples of the plastic include polystyrene, polyethylene, polypropylene, polyurethane, and polyacrylic plastic.

The low melting-point solder particles may be in SnAgCu, which has a melting point of 150°C or lower, or the like.

Of these conductive materials, nickel, particles or the like as the metal particles are preferred.

When the resin conductive paste or conductive film is used for the connection of the rear surface electrode and the rear surface tab line to each other, more preferably also used for a further connection of the cell electrode and the front surface tab line to each other, the temperature required for the connection(s) can be lowered into the range of 150 to 180°C. Thus, warps or cracks in the solar battery cell can be decreased in the production process.

Available examples of the resin conductive pate or resin conductive film used in the solar battery cell of the present invention include die bond paste "EPINAL" series, die bond film "HIATTACH" series, and conductive film "CF" series manufactured by Hitachi Chemical Co., Ltd.

When the resin conductive paste or conductive film is used in the solar battery cell of the present invention to connect the aluminum layer as the rear surface electrode to the rear surface tab line, it is unnecessary to set up any rear surface silver electrode for collecting electricity, and the aluminum layer and the P⁺ layer can be provided onto the whole of the reverse light-receiving surface of the crystalline silicon substrate. The structure thereof is more preferably a structure wherein a resin conductive paste or conductive film as described above is used also to connect the cell electrode and the front surface tab line to each other.

Structures other than the above may be made equal to those of an ordinary silicon-crystalline-type solar battery cell.

The solar battery cell of the present invention can be produced, for example, as follows:

A p-type silicon substrate with 100 to 350 µm thickness obtained by slicing a cast ingot is used, and a damage layer of its silicon surface is removed, by a thickness of 10 to 20 µm, with sodium hydroxide, sodium hydrogencarbonate or the like, the concentration of which is from several percentages to 20% by mass. Thereafter, the workpiece is subjected to anisotropic etching with a solution wherein IPA (isopropyl alcohol) is added to the same low-concentration-alkali solution to give a concentration of 0.1 to 20% by mass. In this way, a textured structure is formed. Subsequently, the workpiece is treated with a mixed gas atmosphere of phosphorus oxychloride (POCl₃), nitrogen and oxygen at 800 to 900°C for several tens of minutes to form an n-type layer with 0.01 to 0.4 µm film thickness uniformly onto its light-receiving surface.

Furthermore, a silicon nitride film, titanium oxide film or the like is formed, as an antireflective coating, into a uniform thickness (film thickness: 50 to 200 nm) on the light-receiving surface of the n-type layer. When the silicon nitride film is formed, the formation is performed by plasma CVD, sputtering, vacuum evaporation, or the like. When the titanium oxide film is formed, the formation is performed by plasma CVD, sputtering, vacuum evaporation, or the like_

Next, in order to form a cell electrode onto the light-receiving surface (front surface), a silver paste for cell electrode is caused to adhere onto the light-receiving surface of the crystalline silicon substrate by screen printing, and then dried. In this case, the paste for cell electrode is formed on the antireflective coating, and relatively thick electrode lines (referred to as "bus bars") for extracting electric power, and thin electrode lines (referred to as "fingers") extended over the whole of the surface are formed by the printing.

Next, an aluminum paste for rear surface electrode is printed and dried also on the reverse light-receiving surface (rear surface) of the crystalline silicon substrate in the same manner as on the light-receiving surface side so as to form a film of the aluminum paste (film thickness: 10 to 200 µm) uniformly onto the reverse light-receiving surface.

The silver paste and the aluminum paste used therein may be ordinary pastes used to form electrodes (for example, pastes described as examples in JP-A Nos. 2008-150597, 2008-120990, 2008-195904, 2008-186590, 2007-179682, and 2008-85469).

Next, the cell electrode and the rear surface electrode are fired, so as to complete a solar battery cell. The electrodes are fired at a temperature within the range of 600 to 900°C for several minutes so that on the reverse light-receiving surface side, aluminum in the aluminum paste is diffused onto silicon of the crystalline silicon substrate on the reverse light-receiving surface side. In this way, a p⁺ layer is formed as a BSF (back surface field) layer for improving the capability of electric power generation. In the solar battery cell of the present invention, it is unnecessary to set up any rear surface silver electrode; therefore, the BSF layer can be provided over the maximum area.

Next, a module step is conducted. A resin conductive paste or resin conductive film is used to connect the uniform rear surface electrode (aluminum layer) on the reverse light-receiving surface to the tab line thereon. In a manner for the connection, the resin conductive paste or resin conductive film that is beforehand made into a semi-cured state is caused to adhere temporarily onto each of the tab lines. Thermal compression is then conducted between the cell electrode and the front surface tab line, and between the rear surface electrode and the rear surface tab line simultaneously on the front and rear surface sides. The temperature at this time is from 150 to 180°C.

For the connection of the cell electrode (silver electrode) to the tab line on the light-receiving surface, solder may be used. However, it is preferred to use the resin conductive paste or conductive film in the same manner as for the connection of the rear surface electrode to the tab line.

The tab lines used in the solar battery cell of the present invention may each be a copper ribbon subjected to anticorrosion treatment, or some other member.

### Examples

Hereinafter; the present invention will be described in detail by way of examples; however, the present invention is not limited thereto.

### (Example 1)

A process for producing a solar battery cell of the present invention will be described hereinafter.

A p-type silicon substrate with 350 µm thickness obtained by slicing a cast ingot was used, and a damage layer of its silicon surface was removed by a thickness of 10 µm with a 5% by mass sodium hydroxide or sodium hydrogencarbonate. Thereafter, the workpiece was subjected to anisotropic etching with a solution wherein IPA (isopropyl alcohol) was added to the same low-concentration-alkali solution to give a concentration of 5% by mass. In this way, a textured structure was formed.

Subsequently, the workpiece was treated with a mixed gas atmosphere of phosphorus oxychloride (POCl₃), nitrogen and oxygen at 800°C for 30 minutes to form an n-type layer with about 0.2 µm film thickness uniformly onto its light-receiving surface.

Furthermore, an antireflective coating of a silicon nitride film was formed into a uniform thickness (film, thickness: 0.12 µm) on the ligiit-receiviiig surface of the n-type layer by plasma CVD. Next, a silver paste for cell electrode was caused to adhere thereto by screen printing, and then dried. In this case, the paste for cell electrode was formed on the antireflective coating, and relatively thick electrode lines (referred to as "bus barts") for extracting electric power, and thin electrode lines (referred to as "fingers") extended over the whole of the light-receiving surface were formed by the printing. Next, an aluminum paste for rear surface electrode was printed and dried also on the reverse light-receiving surface side in the same manner as on the light-receiving surface side so as to form a film of the aluminium paste (film thickness: 50 µm) uniformly onto the reverse light-receiving surface.

Next, the electrodes were fired, so as to complete a solar battery cell. The electrodes were fired at 800°C for 10 minutes so that on the reverse light-receiving surface side, aluminum in the aluminum paste was diffused onto silicon of the crystalline silicon substrate on the reverse light-receiving surface side. In this way, a p⁺ layer was formed as a BSF (back surface field) layer for improving the capability of electric power generation.

Next, in order to connect the cell electrode (silver electrode) on the light-receiving surface to a front surface tab line, and connect the aluminum layer, as the uniform rear surface electrode, on the reverse light-receiving surface to a rear surface tab line, a resin conductive film (product name: CF-105, manufactured by Hitachi Chemical Co., Ltd.) in a semi-cured state was caused to adhere temporarily onto each of the tab lines in advance. Thermal compression was then conducted between the cell electrode and the front surface tab line, and between the rear surface electrode and the rear surface tab line at 180°C, simultaneously on the front and rear surface sides, for 20 seconds. In this way, a solar battery cell as illustrated in FIG. 2 was yielded.

### (Comparative Example 1)

A p-type silicon substrate with 350 µm thickness obtained by slicing a cast ingot was used, and a damage layer of its silicon surface was removed by a thickness of 10 µm with a 5% by mass sodium hydroxide or sodium hydrogencarbonate. Thereafter, the workpiece was subjected to anisotropic etching with a solution wherein IPA (isopropyl alcohol) was added to the same low-concentration-aikali solution to give a concentration of 5% by mass. In this way, a textured structure was formed.

Subsequently, the workpiece was treated with a mixed gas atmosphere of phosphorus oxychloride (POCl₃), nitrogen and oxygen at 800°C for 30 minutes to form an n-type layer with about 0.2 µm film thickness uniformly onto its liglit-receiving surface.

Furthermore, an antireflective coating of a silicon nitride film was formed into a uniform thickness (film thickness: 0.12 µm) on the reverse light-receiving surface of the n-type layer by plasma CVD. Next, a silver paste for front surface cell electrode was caused to adhere thereto by screen printing, and then dried. In this case, the paste for front surface cell electrode was formed on the antireflective coating, and relatively thick electrode lines (preferred to as "bus bars") for extracting electric power, and thin electrode lines (referred to as "fingers") extended over the whole of the light-receiving surface were formed by the printing.

Next, an aluminum paste for rear surface electrode was printed and dried also on the reverse light-receiving surface side in the same manner as on the light-receiving surface side so as to form a film into a film thickness of 50 µm. In this case, it was difficult to connect the rear surface tab line electrically to the aluminum layer as the rear surface electrode; therefore, a region having no aluminum was made, and a silver paste was used therein to form a silver electrode.

Next, the electrodes were fired, so as to complete a solar battery cell. The electrodes were was fired at 800°C for 5 minutes so that on the reverse light-receiving surface side, aluminum in the aluminum paste was diffused onto silicon of the crystalline silicon substrate on the reverse light-receiving surface side. In this way, a p⁺ layer was formed as a BSF (back surface field) layer for improving the capability of electric power generation. For this reason, in the region having no aluminum, this structure was not obtained. Thus, the efficiency was lowered accordingly.

Next, a module step was conducted. A flat copper line coated with solder, that is, a front surface tab line was put onto the cell electrode, and then a lamp heater and hot wind were used to connect the cell electrode to the front surface tab line. The temperature at this time was about 260°C. It is difficult to connect the rear surface tab line to the aluminum in using solder; therefore, it was necessary to set up a silver electrode onto the reverse light-receiving surface, In the same way as for connecting the front surface cell electrode to the front surface tab line, a flat copper line coated with solder (rear surface tab line) was put onto the rear surface silver electrode, and then a lamp heater and hot wind were used for connecting the cell electrode to the front surface tab line.

In the crystalline-silicon-type solar battery cell of Comparative Example 1, no P⁺ layer is formed in the area around the silver electrode on the reverse light-receiving surface. Thus, the cell is in a disadvantageous form as an electric power generating clement. For the connections between the electrodes and the tab lines, a heat for a temperature of about 260°C is required. As a result, from a difference in thermal expansion coefficient between silicon and copper, which is the tab line material the solar battery cell is warped to be easily cracked. Thus, the yield is lowered.

On the other hand, the solar battery cell of the present invention described in Example 1 is a cell for lessening such problems, and aims to remove wastes of the electric power generating element structure, thereby improving the efficiency of electric power generation and further decreasing costs for members thereof Furthermore, warps or cracks in the solar battery cell can be decreased; thus, the yield can be made high.

### Industrial Applicability

It becomes possible to provide a solar battery cell wherein wastes of the element structure are removed, thereby making it possible to improve the efficiency of electric power generation and further decrease costs for members thereof.

## Claims

1. A solar battery cell comprising: a crystalline silicon substrate;
a cell electrode for extracting external electric power formed on a light-receiving surface of the crystalline silicon substrate;
a front surface tab line connected to the cell electrode;
a rear surface electrode formed on a reverse light-receiving surface of the crystalline silicon substrate; and
a rear surface tab line connected to the rear surface electrode,
wherein the rear surface electrode and the rear surface tab line are connected with a resin conductive paste or conductive film, and the rear surface electrode is uniformly formed on the reverse liglit-receiving surface of the crystalline silicon substrate.

2. The solar battery cell according to claim 1, wherein the front surface tab line and the cell electrode are connected with a resin conductive paste or conductive film.
